# EUROPEAN PATENT APPLICATION

(11) **EP 4 514 076 A1**
(43) Date of publication of application: **26.02.2025**
(21) Application number: 24195904.8
(22) Date of filing: 22.08.2024
(51) Int. Cl.: H05K 3/00

(54) **EQUIPMENT AND METHOD FOR SEPARATING PRINTED CIRCUIT BOARDS**

(30) Priority: 22.08.2023 IT 202300017481
(71) Applicant: BST di Busatta Luigi, 10016 Montalto Dora (TO) (IT)
(72) Inventor: Busatta, Luigi, 10016 Montalto Dora (IT)
(74) Representative: Nola, Eduardo

(57) **Abstract**

A separation equipment (20) for printed circuit boards (PCB) from a base board (22), comprising an operating head (27) with a spindle (28) for a separation tool (29), a workpiece table for the base board and movement between the operating head and the board along a first direction (X) and a second direction (Y). The equipment comprises a gripping structure (36) for the base board and a contrasting unit (38) extending along the first direction for contrasting a part of the base board during separation and which delimits a free passage channel (41) for the operations of the separation tool. A board shifting unit (40) moves the gripping structure along the second direction, together with the base board in a gripping condition; and wherein the separation operations are performed by means of movement of the operating head along the first direction and movement of the gripping structure with the workpiece to be separated along the second direction. The width of the passage channel is adjusted in agreement with the diameter of the separation tool; and a workpiece pressing group (49) on the operating head pushes the printed circuit board to be separated and the base board against the contrasting unit in an area around the tool with a stabilizing function during the separation operations.

## Description

### FIELD OF THE APPLICATION

The present invention relates to equipment and a method for separating individual printed circuit boards (PCBs) from base boards.

Specifically, the invention relates to equipment and a method for separating individual PCBs from base boards, wherein the equipment comprises an operating head with a spindle for a separation tool, a workpiece table for the base board, with movement between the operating head and the board along a first direction (X) and a second direction (Y) in accordance with the introductory part of claim 1.

### BACKGROUND OF THE INVENTION

In electronic and computer applications, large quantities of printed circuit boards are used, often of limited size, produced in groups on base boards for drilling and finishing operations on the conductive tracks. Typically, base boards are stacked to form stacks, properly aligned using pins and position holes. The stacks of boards are then placed on the workpiece table of separation equipment. The individual printed circuit boards are separated from the stack by a cutting mill mounted on a rotating spindle of an operating head, with movement of the workpiece table relative to the operating head by means of numerical control systems (CNC).

To optimally perform the separation milling even on the lower base board of the stack, a sacrificial board is interposed between the stack and the workpiece table. During separation, the sacrificial board is irreparably incised and disboarded at the end of operations. This process results in waste, the need for disposal of the sacrificial boards, and is rather slow due to the preparation times of the stacks and the separation of the individual circuits. Moreover, it does not ensure precise execution of the separation operations on all the boards in the stacks.

In the field of wooden components, patent application DE 10 2013 008 368 describes a machine for separating the component from a wooden panel, comprising an operating head with a spindle for a separating tool, a series of roller bars for the panel with movement between the operating head and the panel along a first direction and a second direction, a series of gripping structures engage a rear part of the panel and slide in feed channels between the roller plates to move the panel along the second direction. Transversally to the longitudinal channels there is a cutting channel that allows the tool to pass during use. A machine of this type is not suitable for separating single printed circuit boards (PCBs) from base boards. The support of these boards is in fact hard and thin by nature, the tool exerts large stresses in the cutting areas. Furthermore, operations on single printed circuit boards require high precision.

### SUMMARY OF THE INVENTION

An object of the invention is to provide a separation equipment for individual printed circuit boards from base boards, without pins and sacrificial board, minimizing waste and being fast, precise, and simple to use.

According to the invention, this object is achieved by a separation equipment for printed circuit boards which comprises a gripping structure for the base board, operable between a board insertion condition and a gripping condition, and a contrasting structure extending along the first direction to support a part of the base board during separation and which delimits a free passage channel for the operations of the separation tool. The movement means include a board moving unit for moving the gripping structure along the second direction together with the base board in the gripping condition, and in which the width of the passage channel is adjustable in dependence on the diameter of the tool in accordance with the characteristic part of claim 1.

Correspondingly, the separation method uses equipment comprising a workpiece table for the base board, an operating head having a spindle for a separation tool, and movement between the operating head and the board along a first direction (X) and a second direction (Y), a gripping structure for the base board, and a contrasting structure extending along the second direction to support. During separation, a part of the base board is cantilevered from the workpiece table, and movement between the operating head and the board is carried out by a head moving unit for moving the operating head along the first direction (X), and a board moving unit for moving the gripping structure and the board sliding on the workpiece table and the contrasting structure along the second direction (Y), and in which the width of the passage channel is adjustable in dependence on the diameter of the tool in accordance with the characteristic part of claim 15.

The structure of the separation equipment and the method defined above allow individual printed circuit boards to be separated from base boards with minimal waste, reduced preparation times, and great accuracy.

### BRIEF DESCRIPTION OF THE DRAWINGS

The characteristics of the invention will become clear from the following description, provided by way of example but not limitation, with the aid of the accompanying drawings, in which:
Fig. 1 represents a schematic front view of separation equipment for printed circuit boards from base boards in accordance with the invention;
Fig. 1a is a schematic view of a base board;
Fig. 2 shows a partial schematic view of the equipment in Fig. 1;
Fig. 3 is a schematic enlarged view of some components of the equipment in Fig. 2;
Fig. 3a shows the components of Fig. 3 in an operational condition;
Fig. 4 shows another partial schematic view, on an enlarged scale, of some components of the equipment in Fig. 1;
Fig. 5 is a schematic enlarged view of other components of Fig. 1;
Fig. 6 is a detailed schematic view of some components of Fig. 5;
Fig. 7 is a detailed schematic view of other components of Fig. 5;
Fig. 8 is a schematic front view of the components of Fig. 5;
Fig. 9 represents a schematic side section of some components of the equipment in Fig. 1 in an operational condition;
Fig. 9a shows the components of Fig. 9 in a different operational condition;
Fig. 10 is a schematic rear view of other components of the equipment in Fig. 1;
Fig. 10a shows a schematic enlarged view of some details of Fig. 10;
Fig. 11 is a schematic rear view of a different version of the equipment in Fig. 1;
Fig. 12 is a schematic front view of a version of the equipment in Fig. 1 for particular treatments on the base boards; and
Fig. 12a is a schematic view of a base board with the treatments provided by the equipment in Fig. 12.

### DETAILED DESCRIPTION OF THE PREFERRED EMBODIMENT

Reference 20 designates a separation equipment for a plurality of individual printed circuit boards (PCBs) 21. The printed circuit boards 21 are part of a base board 22 and are to be individually separated from the base board. The equipment 20 is represented in relation to the horizontal coordinate axes X (transversal) and Y (longitudinal) and the vertical coordinate axis Z.

The separation equipment 20 operates on substantially rectangular base boards 22. The printed circuit boards 21 are generally rectangular and arranged with their sides parallel to the sides of the base boards, but the equipment 20 can also operate with base boards of different shapes and for the separation of printed circuit boards with curved edges.

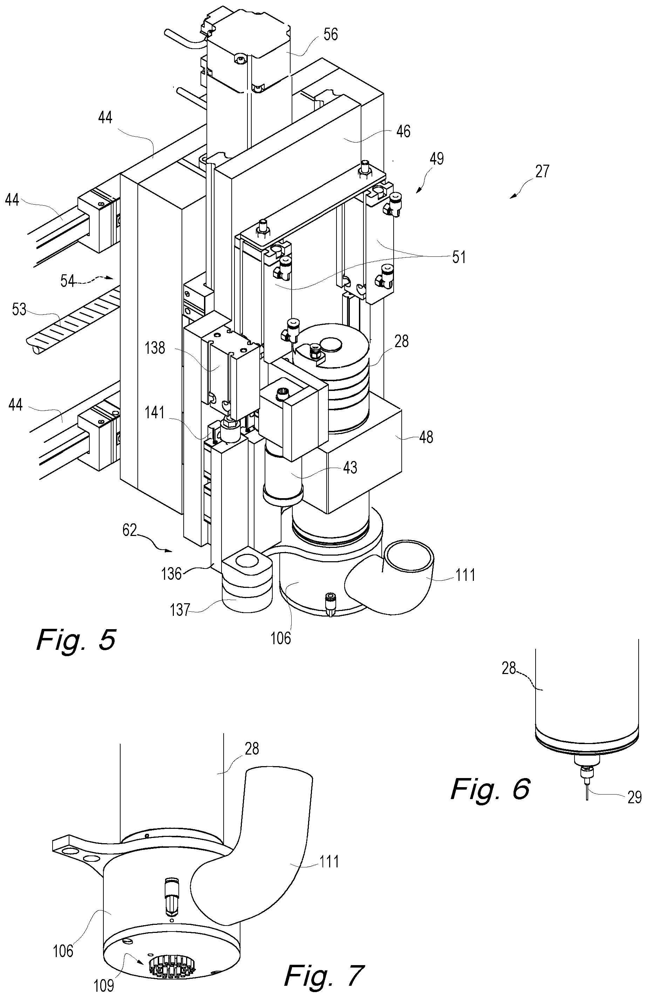

In summary, the separation equipment 20 features a base 23 with a reference plane 24, a workpiece table 25 for the base board 22, a gantry 26, an operating head 27 with a motorized spindle 28 for a separation tool 29 (see Fig. 6) specific movement means between the operating head and the base board. The equipment 20 further includes an electrical control unit 30, a control console 31 supported by an articulated arm, and a waste container 32 below the plane 24.

The equipment 20 can also perform other operations on the base board 22, such as through or blind drilling, reaming, and countersinking, with suitable tools, before the separation of the printed circuit boards 21.

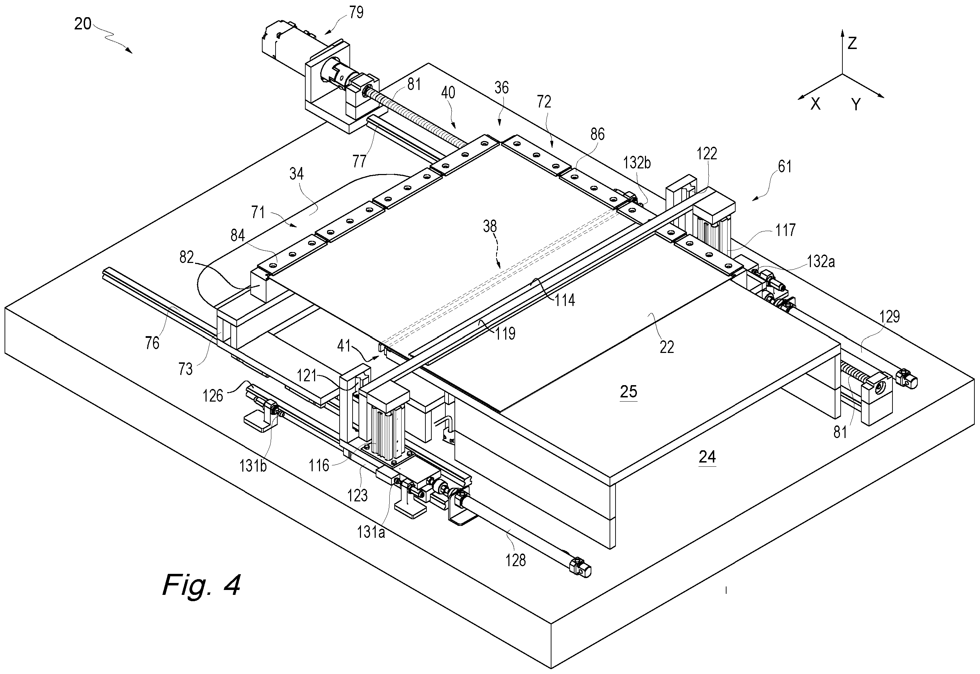

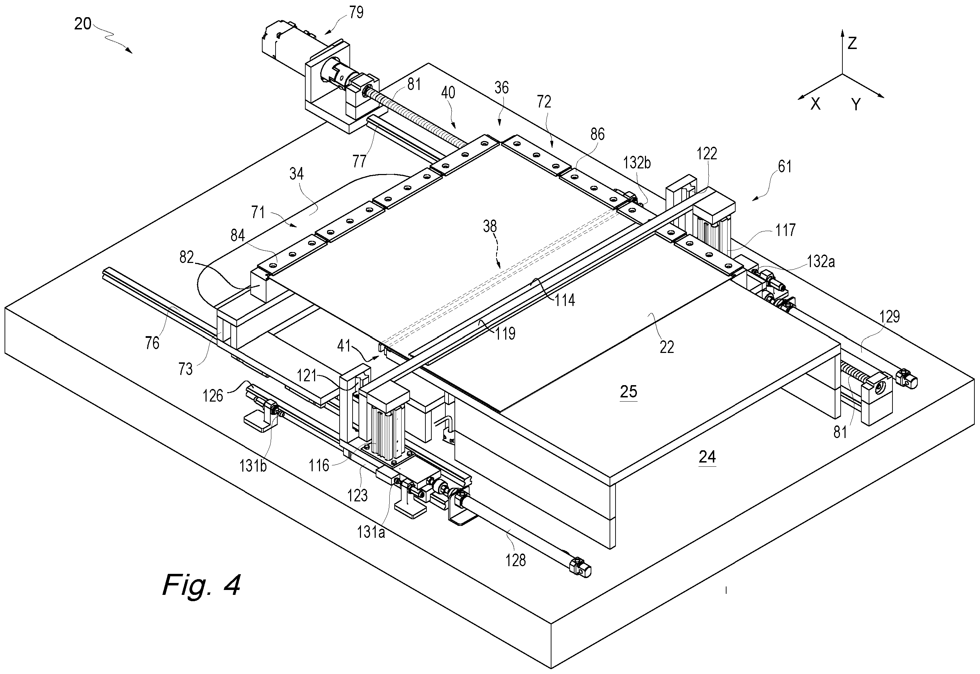

The reference plane 24, for example made of granite, is placed on the base 23 with antivibration elements. The reference plane 24 serves as a fixing support for the workpiece table 25 and for the gantry 26 and defines an access window 34 (see Fig. 4) to the container 32.

The workpiece table 25 occupies a front part of the reference plane 24 above the window 34, extending transversally in a first direction along the X axis and longitudinally in a second direction along the Y axis.

The gantry 26 is positioned behind the workpiece table 25 and defines a crossbeam 35, extending along the X axis, and uprights 35a and 35b, on the left and right in the figure, with a clearance greater than the transversal extension of the table 25.

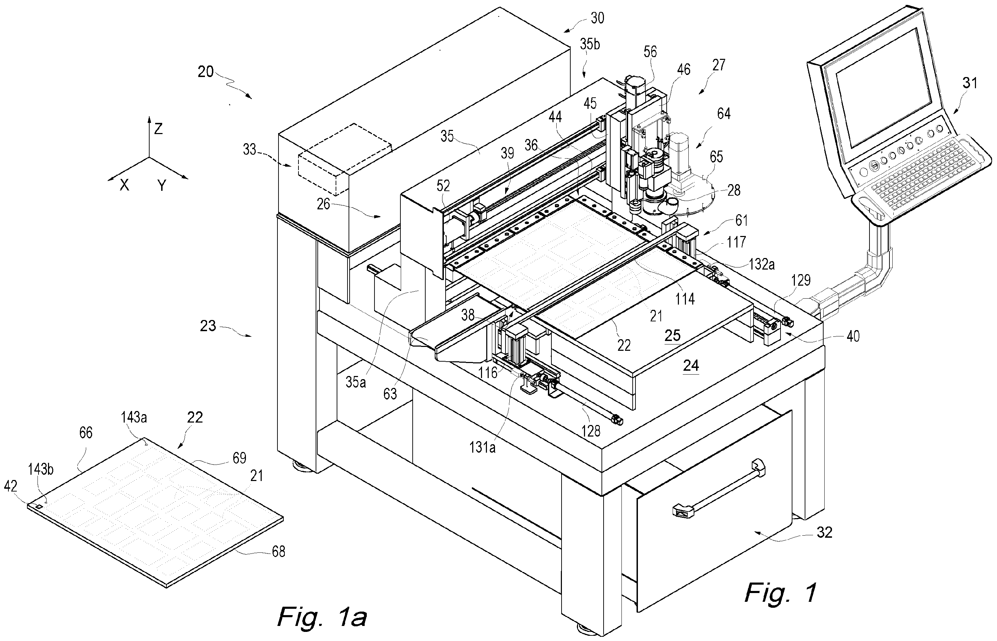

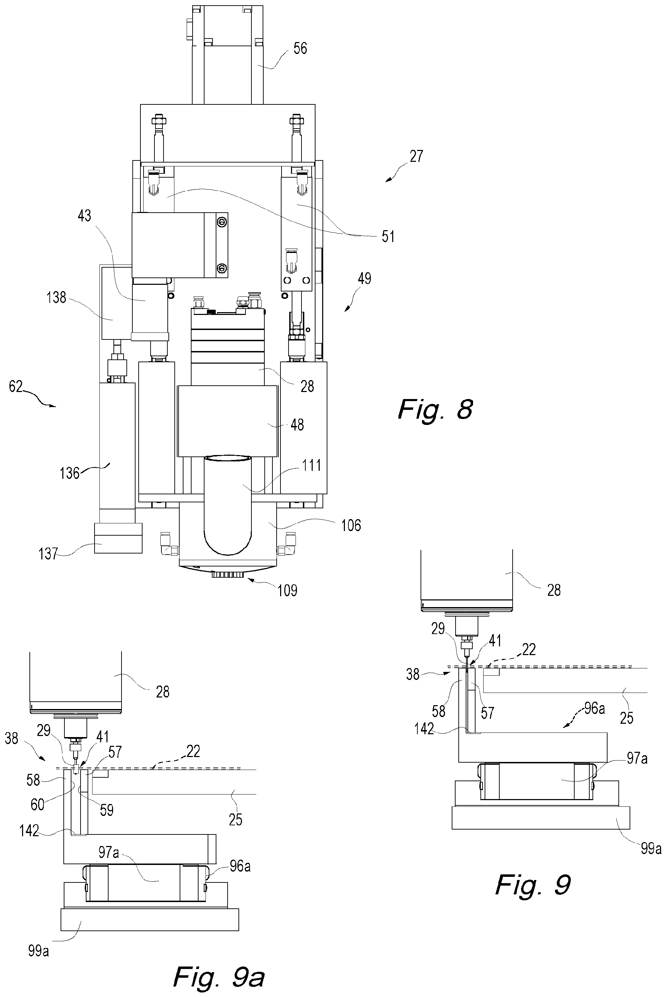

The tool 29 (Figs. 9 and 9a) is generally a milling cutter, and the separation operations are carried out by milling with the movement of the base board 22 relative to the tool 29 along a working path that follows the contour of the printed circuit boards 21 (Fig. 1) to be separated.

The control unit 30 can be connected to the power grid and a compressed air source and includes a container housing electrical and pneumatic control and command equipment and an electronic control unit 33 for the functional components of the equipment 20.

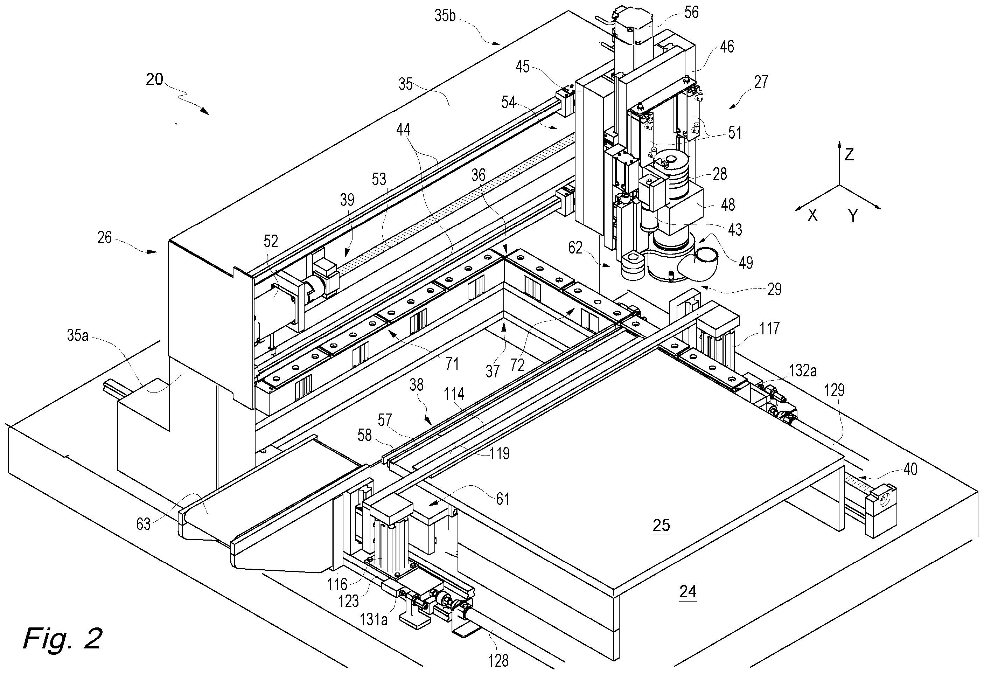

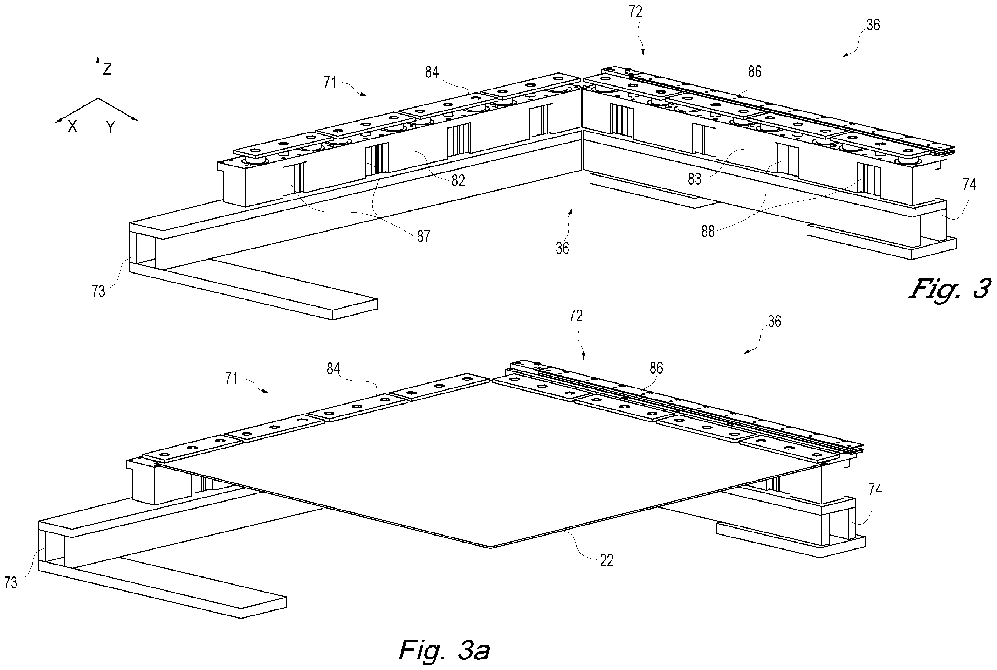

According to the invention, the separation equipment 20 includes a gripping structure 36 operating on the base board 22, a support 37 (Figs. 2 and 3) for the gripping structure, and a contrasting unit 38 for the base board. The movement means between the operating head and the base board include a head shifting unit 39 to move the operating head 27 along the first direction (X) and a board shifting unit 40 (Fig. 4) to move the gripping structure 36, together with the base board 22, along the second direction (Y) in the gripping condition. The gripping structure 36 (Figs. 2, 4, 9, and 10a) extends along the X axis above the window 34, supports the base board in the area to be separated, and defines a passage channel 41 for the movements of the separation tool 29 along the first direction (X).

The separation operations occur with the movement of the operating head 27 along the first direction (X) and the support 37 for the gripping structure and the base board 22 along the second direction (Y), with free housing and movement of the separation tool 29 in the channel 41. The clearance between the uprights 35a and 35b of the gantry 26 allows the movement along the second direction (Y) without interference of the assembly consisting of the gripping structure 36 and the board 22.

The head shifting unit 39 and the board shifting unit 40 are integrated into a CNC system on indication of a program of separation based on AI. The base board 22 includes optically detectable information, for example, from a QR code 42 (see Fig. 1a), on the separation program to be executed. For this purpose, the separation equipment 20 includes a camera 43 mounted on the operating head 27 to detect this information.

In more detail, the gantry 26 features a pair of guide rails 44, parallel to the X axis, fixed to the front part of the crossbeam 35, on which an X-axis slide 45 is mounted slidably.

A Z-axis slide 46 is in turn vertically slidable on the X-axis slide 45 along the Z coordinate and supports the operating head 27.

The operating head 27 (Fig. 5) includes a block 48 for the spindle body 28 mounted on the Z-axis slide 46 and a workpiece pressing group 49 slidable on the slide 46 along the Z coordinate. The slide 46 also mounts the camera 43 and a pair of pneumatically actuated pistons 51 for the workpiece pressing group 49. The operating head 27 also includes a known type of surface sensor, not shown, to detect the distance of the separation tool 29 from the surface of the base board, functional for controlling the working depth.

For the movement of the operating head 27 (Fig. 2), the head shifting unit 39 includes an X-axis servo motor 52 mounted on the crossbeam 35 and a translation mechanism with a worm screw 53 extending along the crossbeam 35 and a nut screw 54 supported by the X-axis slide 45. The movement along the Z axis is carried out by a Z-axis servo motor 56, mounted on the X-axis slide 45, through a translation mechanism with a worm screw not shown in the figures.

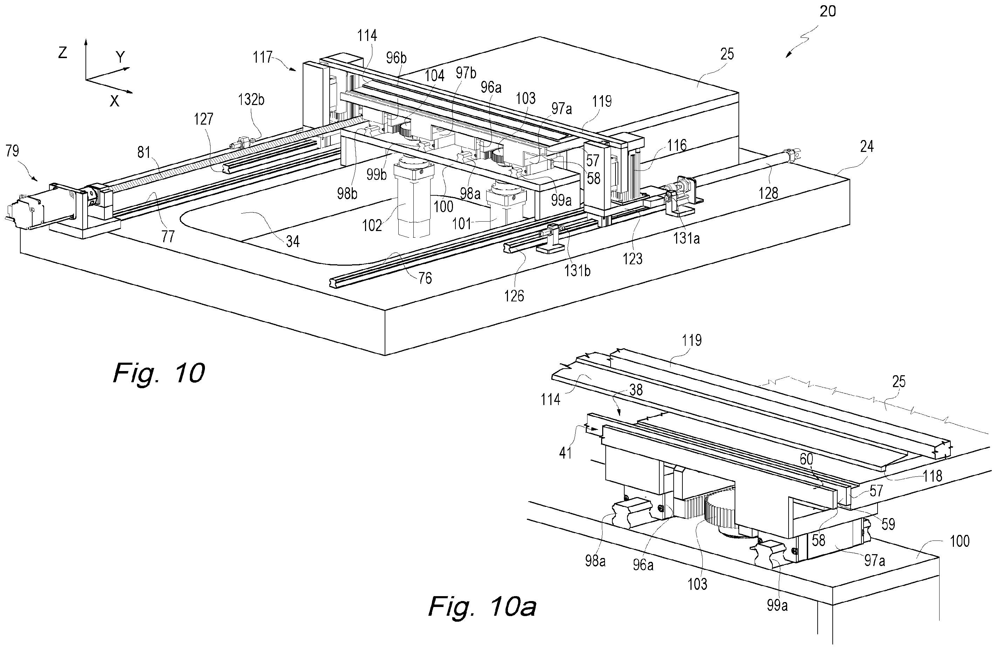

The workpiece table 25 (Figs. 9, 10, and 10a) has a rear edge in front of the contrasting unit 38 and is intended to support the base board 22 with the possibility of sliding, leaving a front part cantilevered from the same workpiece table, resting, still with the possibility of sliding, on the contrasting unit 38. In turn, the contrasting unit 38 includes two flat bars 57 and 58 extended along the X axis with an upper support surface for the cantilevered part of the board and vertical surfaces 59 and 60 facing each other, defining the passage channel 41.

The structure consisting of the gantry 26 and the slides 45 and 46 (Fig. 2) is such that the separation tool 29 operates near and outside the workpiece table 25 and moves in the passage channel 41 between the bars 57 and 58 of the contrasting unit 38, during its movement along the first direction (X), without interference with the workpiece table and the gripping structure.

The gripping structure 36 (Fig. 3) operates on at least one edge (5mm) of the base board 22 to be separated, between an insertion condition of the board and a gripping condition (Fig. 3a) in which it holds the same board with the possibility of sliding on the workpiece table 25 (Fig. 4).

The board shifting unit 40 is designed to move the gripping structure 36 along the (Y) direction, together with the base board 22 in the gripping condition, with sliding on the workpiece table 25 and the contrasting unit 38.

Conveniently, the separation equipment 20 (Fig. 2) also includes a locking device 61, a removal device 62, and a conveyor belt 63.

The locking device 61 is actuated, in use, to lock the base board 22 near the passage channel 41 during the separation of the printed circuit boards 21 from the base board 22 and, optionally, during drilling operations and milling along the X axis. The device 62 is provided to remove the printed circuit boards 21 from the board 22 after separation and to deposit the separated printed circuits onto the conveyor belt 63.

The equipment 20 also includes a tool change group 64 (Fig. 1), which includes a rotating tool magazine 65 and mechanisms for the automatic replacement of the separation tool 29 with different tools for performing other operations. The tool change group is mounted near the upright 35b, on the right in the figure, of the gantry 26, is substantially of a known type, and is not described here as it falls outside the scope of the present invention.

The separation operations are carried out through movements of the operating head 27 along the X and Z axes, by means of the slides 45 and 46, and the base board 22 with the gripping structure 36 along the Y axis, between the uprights 35a and 35b of the gantry 26.

The base boards 22 each have a front edge 66 (Figs. 1a, 2, 3, and 3a), a rear edge 68, and a reference side 69.

The base boards 22 each have a front edge 66 (Figs. 1a, 2, 3 and 3a), a rear edge 68 and a reference side 69:
The gripping structure 36 consists of a transversal vice 71 and a lateral vice 72, arranged at 90° to each other and operating on the edges of the base boards 22 adjacent to the front edge 66 and the side 69 of the boards 22. The vices 71 and 72 have a substantially "L" shaped plan shape on the outside of the workpiece table and an extension towards the front of the lateral vice 72.

The support 37 for the gripping structure consists of a transversal boxed profile 73 and a lateral boxed profile 74, arranged at 90° to each other, behind and to the side of the workpiece table 25 and the contrasting unit 38. The profiles 73 and 74 are slidably mounted by slides on guide rails 76 and 77 along the Y-axis, fixed on the reference plane 24 between the uprights of the gantry 26.

The board shifting unit 40 (Fig. 4) comprises a Y-axis servomotor 79 and a transmission mechanism with a worm screw 81 extended along the Y-axis, partially inside the lateral profile 74, and a nut screw (not visible) supported inside the profile 74. The stroke of the gripping structure 36 is such as to allow separation milling and other machining between parts of the base board 22 adjacent to the front edge 66 and is programmable for separation milling and other machining on parts of the board adjacent to the rear edge 68.

In detail, the vices 71 and 72 (Figs. 2 and 3) include respective fixed jaws 82 and 83, movable jaws 84 and 86 and pneumatic actuators 87 and 88. The jaws 82 and 83 are mounted above the profiles 73 and 74 of the support 37 and have a common gripping surface on the top, substantially tangent to the support surface of the workpiece table 25 and alignment stops for the board 20. The movable jaws 84 and 86 are divided into several segments, operated independently by the actuators 87 and 88.

The stops are substantially aligned respectively along the X-axis for the transversal vice 71 and along the Y-axis for the lateral vice 72. These stops ensure, during the insertion of the base boards 22, accurate positioning for the front edge 66 and for the reference side 69, and therefore for the boards themselves, with respect to at fixed references of the equipment 20.

In the insertion condition of the gripping structure 36, the actuators 87 and 88 arrange the movable jaws 84 and 86 away from the fixed jaws 82 and 83, allowing the front and side edges of the board 22 to rest on the fixed jaws and the precise positioning of the front edge 66 and the reference side 69 against the respective stops.

In the gripping condition (Figs. 2 and 3a), the actuators 87 and 88 operate on the movable jaws 84 and 86, with viceing of the edges of the board between the jaws and the possibility of sliding of the base board 22 on the support surface of the workpiece-table 25. The division of the movable jaws 84 and 86 into several segments and individual actuation ensures an optimal grip of the board to be separated, regardless of the size and thickness of the board itself.

The channel 41 of the contrasting unit 38 (Figs. 9 and 9a) has a variable width, associated with the diameter of the separation tool 29, for optimal support of the board in the milling area, but which ensures that the tool moves along the X and Z axes without interference with the workpiece table and the contrasting member. Advantageously, the structure of the contrasting unit 38 is also such that, by varying the width of the passage channel 41, the axis of the channel remains coplanar with the axis of the spindle 28 during its movement.

In detail, the flat bars 57 and 58 that define the contrasting unit 38 (Figs. 10 and 10a) are shaped so as to present pairs of appendages at the bottom, staggered along the X axis, which are fixed on the rear ends of slides 96a,b and 97a,b. The slides 96a,b and 97a,b are supported in a sliding manner by guide rails 98a,b and 99a,b, extended along the Y-axis and fixed to a frame 100, which is in turn fixed to the reference plane 24.

The slides for the bars 57 and 58 are positioned so that a reference side of the slides 96a and 96b faces an opposite side of the slides 97a and 97b. Furthermore, respective racks are fixed to the opposite sides of the slides. The movement of the bars 57 and 58 is carried out, in opposite directions, along the Y-axis by a pair of servomotors 101 and 102 which operate in synchronism on the slides 96a,b and 97a,b by means of "cremone" mechanisms.

In detail, the servomotors 101 and 102 are connected to two pinions 103 and 104 which engage with opposite sectors the racks of the slides 96a,b and 97a,b: the pinion 103 engages the racks of the slides 96a and 97a, while the pinion 104 engages the racks of the slides 96b and 97b. Thus, a counterclockwise rotation of the pinions 103 and 104 causes the bar 57 and the bar 58 to move away from the axis of the passage channel 41 (Figs. 9 and 9a) with a relative widening of the channel, while a clockwise rotation of the pinions causes the bar 57 and the bar 58 to move closer to the axis of the channel 41 with a relative narrowing.

The workpiece pressing group 49 (Figs. 1, 5, 6 and 7) is designed to press the base board 22 and the printed circuit board 21 to be separated against the workpiece table 25 and against the contrasting unit 38, in proximity to the passage channel 41, during separations and other processes, with a stabilizing function. For example, the workpiece pressing group 49 comprises a cylindrical container 106 with slotted bases, arranged around the body of the mandrel 28 and the possibility of vertical movement by the pistons 51.

In the container 106, the opening of the upper base is slidably coupled with the body of the mandrel 28. The opening of the lower base is a passage for the tool 29 and is surrounded by a crown of elastic stems 109 extended downwards. Following the lowering of the workpiece pressing group 49, the stems 109 press, flexing, on the base board 22 in correspondence with the printed circuit boards 21 and can slide under pressure, without damage, on the board and printed circuit during the movements for the separations.

The container 106 is connected via a pipe 111 to a suction source to remove the processing waste from the upper part of the base board 22. Furthermore, the container is connected to the compressed air source and has a nozzle inside for a jet of air around the tool 29. This, with the function of cooling the tool and expelling other processing waste towards the underlying waste container 32.

The locking device 61 (Figs. 2, 4, 10, 10a) comprises a brake bar 114 that can be operated by an actuator consisting of two pneumatically operated cylinders 116 and 117. The bar 114 is provided with a rear shoulder 118 directed downwards to lock the base board 22 against the workpiece table 25 in the condition of activation of the cylinders 116 and 117.

In detail, the brake bar 114 extends along the X-axis for the width of the workpiece table 25 and is mounted underneath a support bar 119 extending beyond the movement area of the support 37 for the gripping structure. The bar 119 is fixed on the upper ends of the control pistons of the cylinders 116 and 117 and slides via respective slides on vertical guide rails 121 and 122. In turn, the cylinders 116 and 117 are fixed on horizontal slides 123 and 124 mounted slidably on guide rails 126 and 127, extending along the Y axis and fixed on the reference plane 24 outside of the rails 73 and 74.

A pair of pneumatic actuators 128 and 129 acts on the slides 123 and 124 to move the locking device 61 between a front rest position, delimited by limit switches 131a and 132a, and a rear operating position delimited by limit switches 131b and 132b: In the rest position, the actuators 128 and 129 and cylinders 116 and 117 are deactivated and brake bar 114 is forward and raised for easy positioning of base board 22. In the operating position, brake bar 114 is close to the rear edge of workpiece table 25 for the locking action of shoulder 118 on base board 22 in the activated condition of cylinders 116 and 117.

The removal device 62 (Figs. 2 and 5) comprises a suction group 136 with a sponge 137 connected to the vacuum source and a pneumatically operated actuator 138. The suction group 136 is mounted with the possibility of sliding on a guide 141 fixed on the Z-axis slide 46 of the operating head 27. In turn, the conveyor belt 63 is arranged in proximity to the upright 35b of the gantry 26, on the left in Fig. 2, substantially aligned with a transversal plane in axis with the bars 57 and 58 of the contrasting unit 38.

The suction group 136 is movable between a rest position in which the sponge 137 is far from the base board 22 and an operating position in which the sponge is pressed on the printed circuit board 21 and holds it for subsequent phases of detachment from the base board and its transport to the conveyor belt 63.

The equipment 20 also provides for the optical detection of the actual position of the base board 22 after its assembly. This is achieved by illuminating the channel 41 and by providing fiducial holes in the base board 22, the transmission illumination of which can be detected by the camera 43.

More specifically, on the bottom of the channel 41 (Fig. 9a) a LED strip 142 is provided to emit a beam of light upwards, while the base board 22 (Fig. 1a) defines at least two fiducial holes 143a and 143b near the front edge 66 left uncovered by the transversal clamp 71 passed by the light beam when they are above the channel 41.

The provision of illumination of the passage channel 41 and the camera or other sensor is particularly useful for executing measurements and controls very accurate and reliable for machine operations and production statistics.

A robotic arm, not shown, can be associated with the equipment 20, programmed for the operations of picking the base boards 22 from a board magazine, positioning them on the gripping member 36, removing the residual parts of the base board 22 and depositing them in a waste magazine. The robotic arm can also be programmed to pick up and transport individual PCBs 21 into a PCB magazine after they have been separated from the base board.

The operation of the separation equipment 20 is as follows.

In an initialization phase, the servomotor 56 moves the Z-axis slide 46 to a raised position, with the operating head 27 spaced from the support surface of the table 25. The head shifting unit 39 (Figs. 1 and 2) moves the X-axis slide 45 to its rest position, at the end of the travel of the crosspiece 35, in proximity to the upright 35b on the right in the figure. In turn, the board shifting unit 40 moves the support 37 of the gripping structure 36 forward, with the transversal vice 71 close to the bar 58 of the contrasting unit 38.

The cylinders 116 and 117 are deactivated, with brake bar 114 spaced from workpiece table 25. The actuators 128 and 129 are also deactivated with advanced positioning of the bar 114 to stop the slides 123 and 124 against the blocks 131a and 132a. The gripping structure 36 is in the insertion condition with the movable jaws 84 and 86 separated from the fixed jaws 82 and 83. The separation equipment 20 is now ready for use.

The operator begins operations by inserting the base board 22, resting on the workpiece table 25, underneath the bar 114 and positioning the front edge 66 and the side 69 against the stops of the jaws 82 and 83. These operations are automatically performed by program, in the case of the presence of the robotic arm

The operator now proceeds with the start from the console 31 to a preliminary phase: The gripping structure 36 passes to the gripping condition (Fig. 3a) in which the actuators 87 and 88 of the vices 71 and 72 operate on the movable jaws 84 and 86, viceing the edges of the base board 22 against the fixed jaws 82 and 83. The pneumatic actuators 128 and 129 are also activated, with backward movement of the bar 114 in proximity of the contrasting unit 38 to stop the slides 123 and 124 against the blocks 131b and 132b. The servomotors 101 and 102 are also activated to maximally space the bars 57 and 58 of the contrasting unit 38 and the LED strip 142 so as to illuminate the fiducial holes 143a and 143b for their detection.

The operating head 27 now makes a scanning stroke up to the upright 35a on the left in the figure to detect in the board 22, via the camera 43, the current positions of the fiducial holes 143a and 143b with respect to the X and Y axes, as references for the CNC system. Further, the camera 43 detects the information from the QR code 42 for access to the specific separation program.

If additional processes are foreseen on the base board 22, the equipment 20 brings the operating head back to the end of the stroke of the crosspiece 35, with the operating head 27 in the field of action of the tool change group 64 and activates the group 64 for the assembly on the spindle 28 of the tool foreseen for these processes. The servomotors 101 and 102 are also activated to space the bars 57 and 58 of the contrasting unit 38 so as to adapt the width of the channel 41 to the diameter of the mounted tool.

The program continues by positioning the base board 22 and the operating head 27 in a condition of alignment of the tool on the X, Y coordinates of the first point of the machining. For this purpose, the head shifting unit 39 moves the operating head 27 positioning the axis of the tool 29 on the coordinate of the X axis of the initial point. The board movement unit 40 (Fig. 4) in turn moves the gripping structure 36, together with the board 22 by positioning the starting point on the relative coordinate of the Y axis. As regards the board, an initial part of it protrudes from the rear edge of the workpiece-holding table, resting on the contrasting unit 38, while the starting point of the machining is above the passage channel 41.

The servomotor 56 is activated, under control of the surface sensor, with lowering of the Z-axis slide 46 in a positioning position of the tool 29 in which the tip is at a reference distance close to the surface of the board. The spindle 28 is rotated and the pistons 51 are activated with lowering of the workpiece pressing group 49 and pressing of the board against the contrasting unit 38 via the elastic stems 109.

Optionally, the locking device 61 is activated, with activation of the cylinders 116 and 117 and consequent lowering of the brake bar 114, with abutment of the shoulder 118 against the base board 22 and locking of the board in the position reached.

The Z-axis servomotor 56 is then activated for a controlled lowering of the slide 46 with perforation of the base board 22 and passage of the tool, without obstacles, in the channel 41 between the facing surfaces of the bars 57 and 58 of the contrasting unit 38. At the end of the processing, the operating head 27 is raised for positioning on a second processing point and the relative execution, in a manner similar to that previously described for the first point. We continue in sequence with all the additional processes foreseen for board 22.

The equipment 20 is prepared for the separations by bringing the operating head back to the end of the stroke of the crosspiece 35, with the operating head 27 in the field of action of the tool change group 64: The group 64 is activated for the assembly on the spindle 28 of the tool 29 foreseen for the separation and the servo-motors 101 and 102 are activated to adapt the width of the channel 41 to the diameter of the mounted tool.

The program continues by positioning the base board 22 and the operating head 27 in a condition of alignment of the tool 29 on the X, Y coordinates of an initial point of the separation path: The head shifting unit 39 moves the operating head 27 positioning the axis of the tool 29 on the coordinate of the X axis of the initial point. The board shifting unit 40 (Fig. 4) in turn moves the gripping structure 36, together with the base board 22, positioning the starting point on the relevant coordinate of the Y axis. In this configuration, the initial part of the board is cantilevered from the workpiece table 25 and is supported on the contrasting unit 38, while the starting point of the separation path is above the passage channel 41.

Also in this case, the servomotor 56 is activated, under control of the surface sensor, lowering the Z-axis slide 46 into the positioning position of the tool 29, the spindle 28 is rotated and the pistons 51 are activated, lowering the workpiece pressing group 49 to press the board against the contrasting unit 38.

A drilling of the board is then performed at the starting point, activating the Z-axis servomotor 56 for a controlled lowering of the slide 46 into a milling position of the separation tool 29 with drilling of the base board 22 and passage of the tool, without obstacles, in the channel 41 between the facing surfaces of the bars 57 and 58 of the contrasting unit 38.

In the case of separation paths extended along the X and Y axes, the program divides the separation path with homogeneous millings along longitudinal sections and along transversal sections, according to optimized sequences. In both sections, in the positioning configuration, the tool 29 is aligned on the X, Y coordinates of a starting point, moving the operating head 27 and the base board 22 in the manner previously described.

For milling the printed circuit boards 21 along the longitudinal sections, the operating head 27 and the base board 22 are aligned on the X, Y coordinates of the start of the section, with the locking device 61 deactivated. After temporary actuation of the locking device 61, the tool 29, in milling configuration, is moved to the reached position of the channel 41, the locking device 61 is deactivated and the board shifting unit 40 is activated, with the operating head stationary. Upon program control, the unit 40 moves the gripping structure 36 progressively along the Y axis, together with the base board 22 in the gripping condition, with sliding on the workpiece table 25 and on the contrasting unit 38. Milling is performed by moving the board 22 on the contrasting unit 38 and freely housing the tool 29 in the passage channel 41.

The separation of the printed circuit boards 21 along the transversal sections, as before, involves the alignment of the operating head 27 and the base board 22 on the X, Y coordinates of the start of the section, with the locking device 61 deactivated. The locking device 61 is now activated by locking the board 22 against the workpiece table 25, the tool 29 is brought, in milling configuration, to the position reached on the channel 41 and the head shifting unit 39 is activated, with the board locked. Upon program control, the unit 39 moves the head 27 progressively along the X-axis. Milling is performed by moving the head 27 and freely moving the tool 29 along the passage channel 41, and by firmly resting the board 22 on the contrasting unit 38.

Both for milling along the longitudinal sections and for milling along the transversal sections, the workpiece pressing group 49 keeps the base board 22 in stable contact against the bars 57 and 58 of the contrasting unit 38. This is due to the action of the elastic stems 109 which slide under pressure on the board and on the printed circuit board during the movement of the operating head 27.

In the case in which the separation path is inclined with respect to the X-axis or curvilinear, the separation occurs by coordinated movements of the operating head and the gripping structure, with the locking device 61 deactivated.

During milling, the processing waste from the upper part of the base board 22 is sucked up by the container 106 and expelled via the pipe 111 to a vacuum source. The waste from the lower part of the board 22 is instead dragged towards the waste container 32 by the jet of compressed air around the tool, emerging through the opening of the lower base of the container.

The printed circuit boards 21 can be removed individually from the equipment 20 after the separation milling from the base board 22 or, outside the equipment 20, in a phase subsequent to the milling of all the printed circuit boards.

For the individual removal of the printed circuit boards 21, after completing the milling around the separate circuit, the slide 46 is raised, moving the tool 29 away from the base board 22. The suction group 136 is then aligned with a central area of the separated circuit by movements of the operating head 27 and the base board 22. The pneumatic actuator 138 is now activated, bringing the unit 136 into the operating position with the sponge 137 pressed on the separate printed circuit in turn contrasted by the contrasting unit 38. The connection of the suction group 136 with the suction source is also opened for a holding action of the circuit board 21 by the suction group via the sponge 137.

In sequence, with the locked board, the pneumatic actuator 138 is deactivated and the head shifting unit 39 is activated: The unit 136 is raised to its rest position together with the printed circuit board 21 which is thus moved away from the contrasting unit 38 and removed from the base board 22. The operating head 27 is in turn moved in proximity to the upright 35b with the suction group 136 above the conveyor belt 63. The closure of the connection with the vacuum source of the suction group 136 causes the printed circuit board 21 to be released onto the underlying part of the conveyor belt 63 for subsequent storage.

After deactivation of the locking device 61, the operating head 27 and the gripping structure 36 can be positioned on the starting point X, Y of the separation path of another printed circuit board, as previously shown.

The milling procedure continues until all the circuits that make up the base board 22 have been separated.

The program is such that the last separation operation occurs by movements of the head 27 along the X-axis and locking of the residual part of the base board by the locking device 61 for a reliable removal of the last separated printed circuit. The equipment 20 then moves to the initial configuration for the removal of the residual parts of the base board 22 and the insertion of a new board.

For removals of the printed circuits 21 outside the equipment 20, the separation paths are not milled along their entire length. On the sides of the individual circuits, "witnesses" are appropriately left as thin unmilled bridges between the circuits and the base board. The milling operations with the "witnesses" are performed for all the printed circuits which therefore remain anchored to the residual parts of the board. Finally, the equipment 20 is brought to the initial configuration.

The operator can then remove the board with all the milled circuits for storage and insert a new board for another milling. The separation of the printed circuits can be carried out manually after the operations of the equipment 20 by simply pressing on the single circuits, with the "witnesses" breaking.

Naturally, without prejudice to the principle of the invention, the embodiments and details of the construction of the board separation equipment may be widely varied with respect to what has been described and illustrated purely by way of non-limiting example, without thereby departing from the scope of the present invention.

For example, the contrasting unit may consist of a single bar arranged behind the rear edge of the workpiece-holding table.

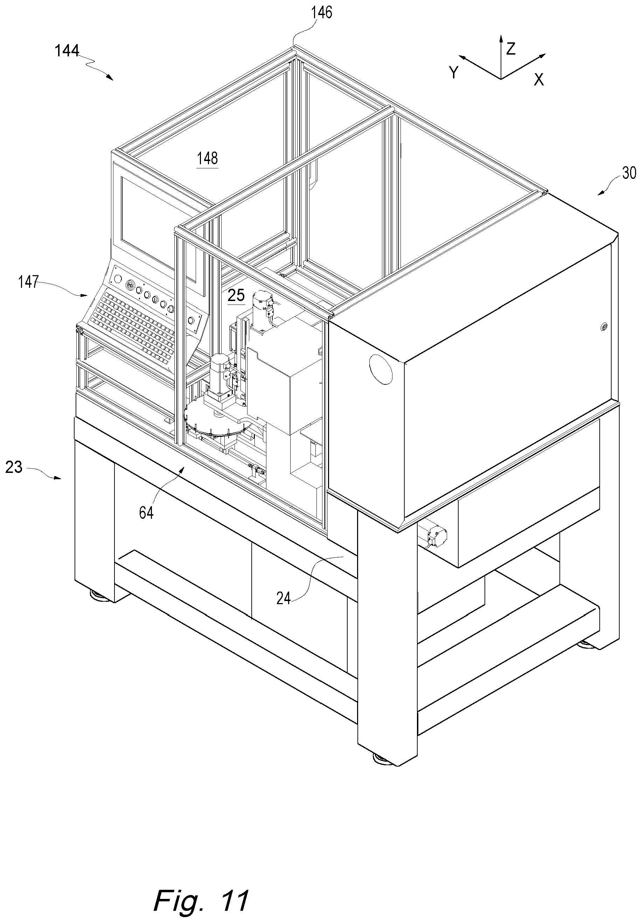

In figure 11, a separation equipment in accordance with the invention is represented with 144, which constitutes a different version of the equipment 20 of Fig. 1.

The separation equipment 144 comprises functional components substantially equal to those of the equipment 20 of Fig. 1. The differences are substantially constituted in the equipment 144 by the presence of a cover 146 and the position of a console 147.

The cover 146 has transparent walls 148 to protect the work area with suitable sections that can be opened for the insertion and removal of the base boards 22 and the printed circuits. The console 147 is in turn arranged on one side of the equipment 144, above the base 23.

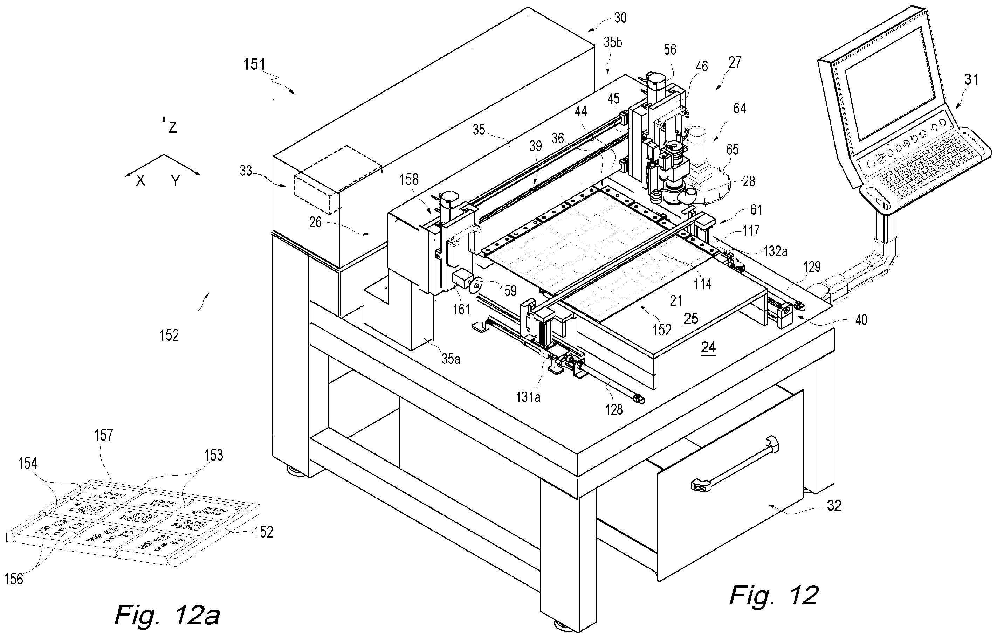

With reference to Figs. 12 and 12a, a separation equipment according to the invention for particular processes on a base board 152 is represented with 151.

The equipment 151 allows in particular to perform on the base board 152 "V" shaped grooves (V-scoring) respectively transversal grooves 153 and longitudinal grooves 154 on the upper and lower surfaces, forming assembly PCB panels 156, each with a group of individual printed circuits 157. The grooves on the upper surface are in line with the grooves on the lower surface and leave a minimum support thickness between the axes of the "V" that is easily breakable for an easy separation of the assembly panels.

The idea behind the V-scoring of printed circuit boards is to provide a robust support structure for the assembly process. This allows minimal pressure to be applied to the boards during automated placement of surface mountable components (SMDs) and later when the assembly panels are separated. Advantageously, the PCB panels allow components to be loaded into the individual PCB board assembly in a fraction of the time required to load components one at a time into the individual boards. In turn, the individual panels can then be easily separated along the axes of the grooves by mutual flexing of adjacent panels.

The separation equipment 151 comprising functional components substantially identical to those of the equipment 20 of Fig. 1. The differences are constituted by the additional presence of an engraving tool head 158 with a scoring tool comprising a disc cutter with V-shaped teeth 159 for forming the grooves, a motor 161 for its rotation and by actuation means controlled by the electronic unit 33 for the execution of the grooves 153 and 154 on the base board 152.

The engraving head 158 is supported by the gantry 26 and also has the possibility of sliding along the first direction (X) independently of the operating head 27.

In the embodiment of Fig. 9, the disc cutter 159 has a horizontal rotation axis parallel to the X axis. The transversal grooves 153 are performed by the action of the cutter 159 with positioning of the board 152 along the Y axis by means of the gripping structure 36 in the desired position, its locking by the device 61 and the operative movement of the engraving head 158 along the X-axis.

After completing all the transversal grooves, the board 152 is rotated by 90°, performing the longitudinal grooves 154 in a similar manner. The board is then overturned and repositioned to perform the transversal and longitudinal grooves on the opposite face, as reported for the grooves on the first face. These operations are automated in the case of using the robotic arm.

The longitudinal grooves 154 can be performed without rotation of the board 152 using an engraving head (not shown) in which the scoring tool can be rotated by 90°: The transversal grooves 153 are with positioning of the card along the Y-axis and milling along the X-axis as in the previous case. For the longitudinal grooves 154, the positioning of the scoring tool occurs by moving the engraving head 158 along the X-axis while the milling of the board occurs, by moving the base board 152, without locking, along the Y-axis.

In a further variant of the separation equipment 20, also not shown, the scoring tool with the possibility of rotation of 90° can be mounted on the same operating head 27, with actuation separate from that of the spindle 28

## Claims

1. Separation equipment for printed circuit boards (PCB) from a base board, comprising an operating head with a spindle for a separation tool, a workpiece table for the base board and movement between the operating head and the board along a first direction (X) and a second direction (Y), the said equipment being **characterized in that** it comprises
a gripping structure for the base board operable between an insertion condition of the board and a gripping condition;
a contrasting unit extending along the first direction for supporting a part of the base board during separation and which delimits a free passage channel for the operations of the separation tool; and
a board shifting unit for moving the gripping structure along the second direction, together with the base board in the gripping condition; and wherein the separation operations are performed by means of movement of the operating head along the first direction and movement of the gripping structure with the workpiece to be separated along the second direction, the said equipment being **characterized in that** the width of the passage channel is adjustable and **in that** said equipment further comprises
an adjustment mechanism for modifying the width of the passage channel so as to adapt said width to the diameter of the separation tool; and
a workpiece pressing group mounted on the operating head and operable to push the printed circuit board to be separated and the base board against the contrasting unit in an area around the tool with a stabilizing function during the separation operations.

2. Separation equipment for single printed circuits according to claim 1 **characterized in that** it comprises a support for the gripping structure, wherein the workpiece table supports a cantilevered part of the base board and has a rear edge adjacent to the contrasting unit, said support is formed by two profiles arranged, in plan, at 90° to each other, behind the contrasting unit and to the side of the workpiece table, the support is slidable on a pair of guides at the sides of the workpiece table and the board shifting unit moves said support with sliding of the base board on the workpiece table and on the contrasting unit, while the gripping structure includes two sets of vices distributed along said profiles and operating on one side and on one front of the board to be separated and wherein the vices include respective fixed jaws, movable jaws and actuators for the movable jaws, the fixed jaws have a common gripping surface on the top and substantially aligned stops, wherein in a board insertion condition, the gripping surface is a support for the base board and the stops are functional to a precise positioning of the board and in which, in the gripping condition, the actuators vice the edges of the base board between the movable jaws and the fixed jaws.

3. Separation equipment for single printed circuits according to claim 1 or 2, **characterized in that** it comprises a locking bar actuatable for locking the base board against the workpiece table in proximity to the contrasting unit.

4. Separation equipment for single printed circuits according to one of the preceding claims, **characterized in that** the contrasting unit comprises two bars extending along the X-axis with an upper support surface for the base board and surfaces facing each other, which define the passage channel for the tool operations, and in which the adjustment mechanism is designed for moving the bars in opposite directions along the Y-axis so as to maintain the axis of the passage channel in the condition of coplanarity with the axis of the spindle regardless of the channel width.

5. Separation equipment for single printed circuits according to claim 4, **characterized in that** said mechanism is of a "cremone" type with two pairs of support slides for the bars with opposing racks engaged by a pair of control pinions and by a pair of servomotors for the drive of said pinions.

6. Separation equipment for single printed circuits according to one of the preceding claims, **characterized in that** the workpiece pressing group comprises a crown of elastic stems extended downwards that are susceptible to vertical movement by a corresponding actuator and in which said stems, by flexing, can slide under pressure, without damage, on the base board and printed circuit during the movements thereof for the separations.

7. Separation equipment for single printed circuits according to claim 6 wherein the operating head comprises a support body for said spindle, **characterized in that** said workpiece pressing group comprises a cylindrical container with slotted bases, arranged around the spindle body and capable of vertical movement, wherein said container has an upper base slidingly coupled with the spindle body and a lower base for the passage of the tool, supporting a crown of elastic stems, the actuator operates on said container and wherein said container is connected to a suction source for removing processing waste from the upper part of the board.

8. Separation equipment for single printed circuits according to claim 6 or 7 wherein the operating head comprises a nozzle, inside the cylindrical container, if present, connected to a compressed air source for a jet of air around the tool with the function of cooling the tool and expelling other processing waste.

9. Separation equipment for single printed circuit boards according to one of the preceding claims, **characterized in that** the head movement unit and the board shifting unit are integrated into a CNC system, wherein the base board comprises optically detectable information and wherein said equipment comprises a camera mounted on the operating head to detect said information functional to an alignment of the spindle with respect to the printed circuit boards (PCB) to be separated.

10. Separation equipment for single printed circuit boards according to one of the preceding claims, **characterized in that** the passage channel is illuminated from below while the operating head comprises a sensor for detecting by transmission checks of the machining operations carried out, said sensor being constituted by the said camera, if present.

11. Separation equipment for printed circuits according to one of the preceding claims, **characterized in that** it can perform drilling, boring, countersinking and milling operations and wherein said equipment comprises a gantry with a crosspiece along the first direction (X), a sliding support for the operating head and uprights with spaced light to allow free movement of the gripping structure along the second direction (Y) and a tool change group, wherein said tool change group includes a rotating tool magazine and mechanisms for the automatic replacement of the separation tool with different tools in accordance with the operations to be performed and wherein said tool change group is mounted in proximity to one of said uprights.

12. Separation equipment for single printed circuits according to one of the preceding claims, **characterized in that** it comprises a V-scoring tool having the possibility of sliding along the first direction (X) and actuation means for performing V-scoring on the base board.

13. Separation equipment for single printed circuits according to one of the preceding claims, **characterized in that** it comprises gripping and transport means mounted on the operating head for removing the separated single printed circuit from the separation area.

14. Separation equipment for single printed circuits according to claim 13, **characterized in that** said gripping and transport means comprise a suction group connected to a vacuum source and a pneumatically operated actuator and in which the suction group is mounted with the possibility of vertical sliding on the operating head.

15. Separation method for single printed circuit boards (PCBs) from a base board, using equipment comprising a workpiece table for the base board, an operating head having a spindle for a separation tool and movement between the operating head and the board along a first direction (X) and a second direction (Y), **characterized in that** the equipment used also comprises a gripping structure for the base board and a contrasting unit extending along the second direction to support, during separation, a part of the base board projecting from the workpiece table, and in which the movement between the operating head and the board is carried out by means of a head shifting unit for moving the operating head along the first direction (X) and a board shifting unit for moving the gripping structure and the board along the second direction (Y), in which the contrasting unit delimits a passage channel of adjustable width for the operations of the separation tool and in which said separation method comprises milling operations divided into sections along the first direction and sections along the second direction with sliding on the workpiece table and on the contrasting unit in accordance with the following steps:
a) adjusting the width of the passage channel to the diameter of the separation tool;
b) for the sections along the first direction, moving the operating head with movement of the separation tool parallel to the contrasting device; and
c) for the sections along the first direction, moving the gripping device, together with the base board in the gripping condition, with support of the board by the contrasting unit.
